# DEMANDE DE BREVET EUROPEEN

(11) **EP 4 174 221 A1**
(43) Date de publication de la demande: **03.05.2023**
(21) Numéro de dépôt: 21205897.8
(22) Date de dépôt: 02.11.2021
(51) Int. Cl.: C30B 15/34, C30B 29/20, G04B 39/00, B28D 5/00

(54) **PROCÉDÉ DE FABRICATION D'UN GERME DE SAPHIR MONOCRISTALLIN AINSI QUE D'UN MONOCRISTAL DE SAPHIR À ORIENTATION CRISTALLOGRAPHIQUE PRÉFÉRENTIELLE ET COMPOSANTS D HABILLAGE ET FONCTIONNELS POUR L HORLOGERIE ET LA BIJOUTERIE**

(71) Demandeur: Comadur S.A., 2400 Le Locle (CH)
(72) Inventeur: COCHET-MUCHY, Didier, 38570 Hurtières (FR); BERISHA, Naser, 5430 Wettingen (CH); VUILLE, Pierry, 2338 Les Emibois (CH)
(74) Mandataire: ICB SA

(57) **Abrégé**

L'invention concerne un procédé de fabrication d'un monocristal de saphir (6), ce procédé comprenant l'étape qui consiste à faire fusionner de l'alumine et/ou du saphir dans un creuset, puis à amener l'alumine et/ou le saphir en fusion en contact avec un germe de saphir monocristallin (1) afin de faire progressivement cristalliser l'alumine et/ou le saphir en fusion selon une direction de croissance pour former le monocristal de saphir (6), le germe de saphir monocristallin (1) présentant une structure cristallographique rhomboédrique définissant trois axes cristallographiques [A], [C] et [M] mutuellement perpendiculaires et respectivement perpendiculaires aux plans cristallographiques A (11-20), C (0001) et M (10-10), le germe de saphir monocristallin (1) étant une plaque (2) délimitée par deux faces planes (4) qui s'étendent parallèlement et à distance l'une de l'autre, cette plaque de saphir monocristallin (2) étant obtenue à partir d'un monocristal de saphir initial que l'on découpe de sorte que l'un des axes cristallographiques [A], [C] ou [M] de la plaque de saphir monocristallin (2) forme avec une normale (D1) aux faces planes (4) de cette plaque de saphir monocristallin (2) un angle (a) dont la valeur est comprise entre 5 et 85°.

L'invention concerne également un germe de saphir monocristallin et une ébauche de glace de montre obtenue à partir d'un tel monocristal de saphir.

## Description

### Domaine technique de l'invention

La présente invention concerne un procédé de fabrication d'un germe de saphir monocristallin à orientation cristallographique préférentielle. La présente invention concerne également un procédé de fabrication d'un monocristal de saphir à orientation cristallographique préférentielle à partir d'un tel germe de saphir monocristallin. La présente invention concerne encore des composants d'habillage et fonctionnels pour l'horlogerie et la bijouterie découpés dans un tel monocristal de saphir.

### Arrière-plan technologique

Les matériaux dits monocristallins sont constitués d'un unique cristal macroscopique dont la taille peut varier du millimètre à plusieurs mètres. L'une des utilisations de monocristaux la plus familière est celle faite en bijouterie : en effet, de nombreux ornements de bijoux sont réalisés au moyen de monocristaux tels que rubis, saphirs, diamants etc. Bien que souvent méconnu, le rôle des monocristaux dans le domaine des technologies de pointe est cependant primordial puisque le silicium utilisé en électronique et dans certaines cellules photovoltaïques ainsi que les composants utilisés dans de très nombreux lasers solides sont monocristallins. Du simple pointeur laser aux lasers de puissance pour la fusion nucléaire en passant par les turbines d'avions ou l'optique, les applications des matériaux monocristallins sont très variées.

Sous forme de monocristal, un composé peut présenter des propriétés optiques particulières telles la transparence ou la biréfringence.

Pur, le cristal d'alumine Al₂O₃ est transparent et est couramment utilisé pour la fabrication de glaces de montres en horlogerie. Coloré par des dopants ou des impuretés, le cristal d'alumine Al₂O₃ est utilisé en tant que pierre précieuse. L'environnement chimique des atomes et des ions constituant un monocristal étant parfaitement défini et organisé de façon répétitive, un dopant introduit dans cet environnement n'a à sa disposition que quelques sites d'occupation possibles, ce qui permet à ce dopant de donner au monocristal une propriété bien précise. Par exemple, lorsqu'un matériau monocristallin est dopé pour en faire une source d'émission laser, le dopant est distribué sur un nombre limité de sites, de sorte que l'énergie émise par le dopant lors de ses transitions électroniques ne varie que faiblement, ce qui permet d'obtenir une émission laser fine. De même, la définition précise des sites qu'un dopant peut occuper dans un composé monocristallin permet de modifier la propriété inhérente à la présence d'un tel dopant. Par exemple, la présence d'ions Cr³⁺ dans un cristal d'alumine est à l'origine de la coloration rouge du rubis, tandis qu'un béryl (Be₃Al₂Si₆O₁₈) avec le même ion Cr³⁺ sera vert ; on l'appellera alors émeraude.

La présence, sous forme de dopants, de défauts dans un composé monocristallin est donc souhaitée en vue d'applications technologiques. Il en va par contre tout autrement des impuretés non contrôlées, des défauts structuraux comme les dislocations et des fractures. On cherche donc en règle générale à utiliser des monocristaux de la plus grande qualité possible. Il est possible de trouver des monocristaux dans la nature, mais ceux-ci sont généralement rares et très défectueux. C'est pourquoi de nombreuses techniques de synthèse ont été développées depuis le début du XXème siècle. Il existe plusieurs types de procédés pour obtenir un monocristal artificiel :
- à partir d'une solution sursaturée du composé ;
- à partir du composé en fusion ;
- par dépôt chimique en phase vapeur.

On s'intéresse ici à la synthèse des monocristaux par cristallisation à l'état fondu qui représente près de 80% des monocristaux artificiels obtenus. C'est au français Auguste Verneuil que l'on doit le premier procédé de cristallisation à l'état fondu de composés monocristallins. Proposé en 1891 alors que Verneuil cherchait à synthétiser des rubis pour la joaillerie, le procédé consiste à faire cristalliser le matériau fondu au contact d'une fraction d'un monocristal appelé germe préalablement obtenu. Pour synthétiser le corindon de formule Al₂O₃ qui compose les rubis et les saphirs, il est nécessaire de monter à très haute température (fusion à 2050°C), température que l'on atteint au moyen d'un chalumeau oxhydrique H₂ + ½ O₂ →H₂O dont la température de flamme est de 2700°C environ. De l'alumine, éventuellement dopée, est introduite sous forme de poudre fine par un vibreur qui en fait tomber de petites quantités directement dans la flamme du chalumeau. La goutte d'alumine en fusion alors formée tombe au sommet du germe et cristallise en suivant l'arrangement cristallographique de ce germe. Le monocristal en croissance est progressivement abaissé pour que la cristallisation s'opère à température constante. En fin de synthèse, un monocristal en forme de bouteille est obtenu.

Le procédé Verneuil est toujours utilisé aujourd'hui, presque à l'identique, en particulier pour la production industrielle de corindon pour la joaillerie et l'horlogerie (rubis, saphirs, glaces de montres etc.). Bien que donnant des monocristaux plus défectueux que ceux obtenus par d'autres méthodes, le procédé Verneuil présente l'avantage d'être relativement peu onéreux et rapide ; au moyen de cette méthode, il est par exemple possible d'obtenir un monocristal en une dizaine d'heures. Néanmoins, les monocristaux de saphir obtenus par le procédé Verneuil présentent de fortes densités de dislocations et des désorientations locales incontrôlables. D'autres défauts également présents dans les monocristaux Verneuil tels que des bulles, des voiles et autres inclusions sont quant à eux susceptibles de se voir à l'œil nu par exemple dans une glace de montre finie.

La présente invention s'intéresse aux procédés de synthèse de monocristaux par cristallisation à l'état fondu dans un creuset. En particulier, l'invention s'intéresse aux techniques de croissance de monocristaux de type EFG, HEM, Kyropoulos, Czochralski, Bridgman Vertical, Bridgman Horizontal et Micro Pulling Down.

Proposé par J. Czochralski en 1915, le procédé du même nom constitue une méthode emblématique de cristallisation à l'état fondu de monocristaux. Reposant sur le même principe que le procédé Verneuil, à savoir fusion du matériau et croissance cristalline au contact d'un germe monocristallin préalablement obtenu, le procédé Czochralski se distingue néanmoins du procédé Verneuil en ce que le matériau à fusionner, au lieu d'être apporté progressivement par petites quantités, est apporté en totalité et fondu en début d'expérience. Pour cela, on place le matériau à fusionner dans un creuset réalisé en un matériau chimiquement inerte et supportant les hautes températures tel que, entre autres, le platine ou l'iridium. Le creuset est placé au centre de bobines conductrices de l'électricité et parcourues par un courant haute fréquence, ce qui permet de chauffer le creuset par induction. Une fois le matériau fondu et la température stabilisée, un germe monocristallin préalablement obtenu est placé sur une tige réfractaire et amené au contact du matériau en fusion. Le germe est ensuite remonté lentement vers une zone plus froide où le matériau en fusion cristallise au contact du germe. Le monocristal est ainsi tiré du matériau en fusion. La tige réfractaire est en rotation permanente afin d'homogénéiser la couche de matériau en fusion sur le point de cristalliser.

Dans le procédé Czochralski, le contrôle de la température doit être minutieux car on doit se placer très proche de la fusion du matériau à cristalliser sans pour autant que la température soit trop élevée, car cela provoquerait la fusion du germe qui serait perdu. La difficulté de mise en oeuvre du procédé Czochralski est cependant compensée par la haute qualité des cristaux qu'il génère, ce qui en fait une technique de cristallogenèse éprouvée de ce point de vue.

Le saphir ayant la composition chimique Al₂O₃ convient, grâce à ses propriétés physiques exceptionnelles, pour d'innombrables applications. Le saphir est, après le diamant, le matériau le plus dur et le plus résistant et est, de ce fait, utilisable dans l'industrie horlogère et également dans les industries pour les domaines à hautes performances. Le saphir synthétique est inerte, transparent à l'état poli, résistant à l'acide, de faible conductivité électrique et, avec un point de fusion de plus de 2000°C, est approprié pour les utilisations les plus exigeantes. Le saphir est presque indestructible et résiste pratiquement à toutes les agressions extérieures. Les glaces de montres et les composants techniques en saphir résistent aux rayures, leur surface est non-poreuse, brillante et leur transparence parfaite une fois polis.

Comme décrit ci-dessus, les procédés de synthèse de monocristaux par cristallisation à l'état fondu dans un creuset permettent de réaliser des saphirs monocristallins de grande qualité. Ces procédés sont néanmoins coûteux car la qualité des cristaux recherchés nécessite des vitesses de croissance généralement plus lentes ainsi qu'un outillage comme les creusets plus important en nombre et plus complexe. Ainsi, la durée de fabrication d'un monocristal Czochralski peut être de l'ordre d'une semaine ou plus. C'est pourquoi on cherche à produire des monocristaux les plus exempts possible de défauts.

Les glaces de montres sont obtenues par usinage d'ébauches découpées dans un monocristal de saphir. Or, jusqu'à présent, les monocristaux de saphir produits par cristallisation à l'état fondu dans un creuset sont obtenus par croissance de ces monocristaux selon une direction correspondant à l'un des axes cristallographiques principaux, généralement [A] ou [M] du saphir. Ces modes de croissance cristalline conduisent actuellement à des ébauches dont la normale à la surface est l'axe cristallographique [A] ou [M] avec l'axe cristallographique [C] contenu dans cette surface. Or, on s'est rendu compte qu'avec une telle orientation cristallographique, les ébauches présentaient une plus grande fragilité à l'usinage, ce qui conduisait à plus d'ébréchures. Les glaces de montres sont donc plus difficiles à usiner et le taux de rebut est plus important, ce qui augmente sensiblement le prix de revient de telles glaces.

### Résumé de l'invention

La présente invention a pour but de remédier aux problèmes mentionnés ci-dessus ainsi qu'à d'autres encore en proposant un procédé de fabrication de monocristaux de saphir permettant d'obtenir des monocristaux de saphir moins défectueux et plus faciles à usiner.

A titre de remarque préalable, il est important de comprendre que les germes de saphir monocristallins dont il sera question ci-après sont découpés de manière spécifique dans un premier monocristal de saphir, puis que ces germes de saphir monocristallins sont ensuite utilisés pour faire croître des seconds monocristaux de saphir dans lesquels seront découpées les ébauches de glaces recherchées.

A cet effet, la présente invention concerne un procédé de fabrication d'un germe de saphir monocristallin, ce germe de saphir monocristallin présentant une structure cristallographique rhomboédrique définissant trois axes cristallographiques [A], [C] et [M] mutuellement perpendiculaires et respectivement perpendiculaires aux plans cristallographiques A (11-20), C (0001) et M (10-10), ce germe de saphir monocristallin étant une plaque délimitée par deux faces planes qui s'étendent parallèlement et à distance l'une de l'autre, cette plaque de saphir monocristallin étant obtenue à partir d'un monocristal de saphir initial que l'on découpe de sorte que l'un des axes cristallographiques [A], [C] ou [M] de la plaque de saphir monocristallin forme avec une normale aux faces planes de cette plaque de saphir monocristallin un angle dont la valeur est comprise entre 5 et 85°.

Selon une forme spéciale d'exécution, la présente invention concerne également un procédé de fabrication d'un germe de saphir monocristallin, ce germe de saphir monocristallin présentant une structure cristallographique rhomboédrique définissant trois axes cristallographiques [A], [C] et [M] mutuellement perpendiculaires et respectivement perpendiculaires aux plans cristallographiques A (11-20), C (0001) et M (10-10) de la structure rhomboédrique, ce germe de saphir monocristallin étant un barreau préalablement obtenu à partir d'un monocristal de saphir initial que l'on découpe de sorte que l'un des axes cristallographiques [A], [C] ou [M] du barreau de saphir monocristallin résultant forme avec une normale à une section droite de ce barreau de saphir monocristallin un angle dont la valeur est comprise entre 5 et 85°.

Selon une autre forme spéciale d'exécution, la présente invention concerne également un procédé de fabrication d'un monocristal de saphir, ce procédé comprenant l'étape qui consiste à faire fusionner de l'alumine et/ou du saphir dans un creuset, puis à amener l'alumine et/ou le saphir en fusion en contact avec un germe de saphir monocristallin du type d'une plaque ou d'un barreau, afin de faire progressivement cristalliser l'alumine et/ou le saphir en fusion selon une direction de croissance pour former le monocristal de saphir.

Selon une autre forme spéciale d'exécution, la présente invention concerne également un procédé de fabrication d'un monocristal de saphir obtenu par cristallisation à l'état fondu à un sommet d'une filière, ce procédé comprenant l'étape qui consiste à faire fusionner de l'alumine et/ou du saphir dans un creuset, puis à amener au travers de canaux de la filière l'alumine et/ou le saphir en fusion en contact avec un germe de saphir monocristallin préalablement obtenu afin de faire progressivement cristalliser l'alumine et/ou le saphir en fusion selon une direction de croissance pour former le monocristal de saphir, le germe de saphir monocristallin présentant une structure cristallographique rhomboédrique définissant trois axes cristallographiques [A], [C] et [M] mutuellement perpendiculaires et respectivement perpendiculaires aux plans cristallographiques A (11-20), C (0001) et M (10-10) de la structure rhomboédrique, le germe de saphir monocristallin étant une première plaque délimitée par deux faces planes qui s'étendent parallèlement et à distance l'une de l'autre, l'un des axes cristallographiques [A], [C] ou [M] étant perpendiculaire aux faces planes de la première plaque de saphir monocristallin, cette première plaque de saphir monocristallin étant inclinée d'un angle dont la valeur est comprise entre 5 et 85° par rapport à une perpendiculaire au plan défini par les canaux de la filière, le monocristal de saphir résultant de la croissance cristalline étant une seconde plaque de saphir monocristallin délimitée par deux faces planes qui s'étendent parallèlement et à distance l'une de l'autre, cette seconde plaque de saphir monocristallin présentant une désorientation de ses axes cristallographiques [A], [C] ou [M] par rapport à la normale à ses faces planes qui correspond à l'inclinaison de la première plaque par rapport aux canaux de la filière.

Selon des formes particulières de mise en œuvre du procédé selon l'invention :
- l'axe cristallographique [A] ou [M] ou [C] forme avec la normale aux faces planes de la plaque de saphir monocristallin un angle dont la valeur est comprise entre 25 et 35° ;
- l'axe cristallographique [A] ou [M] ou [C] forme avec la normale aux faces planes de la plaque de saphir monocristallin un angle dont la valeur est comprise entre 5 et 15° ;
- l'axe cristallographique [A] ou [M] ou [C] forme avec la normale à la section droite du barreau de saphir monocristallin un angle dont la valeur est comprise entre 25 et 35° ;
- l'axe cristallographique [A] ou [M] ou [C] forme avec la normale à la section droite du barreau de saphir monocristallin un angle dont la valeur est comprise entre 5 et 15° ;
- le procédé de fabrication du monocristal de saphir est choisi parmi les procédés EFG, HEM, Kyropoulos, Czochralski, Bridgman Vertical, Bridgman Horizontal et Micro Pulling Down ;
- l'alumine et/ou le saphir que l'on fait fusionner sont purs ou dopés ;
- on utilise des rebuts de saphir ;
- une fois le monocristal de saphir obtenu, on découpe des composants d'habillage ou fonctionnels pour l'horlogerie et la bijouterie dans ce monocristal de saphir ;
- les composants d'habillage ou fonctionnels sont des ponts, des platines, des glaces, des boîtes et des cadrans de montre ou bien des maillons de bracelet.

Selon encore une autre forme spéciale d'exécution, la présente invention concerne un procédé de fabrication d'un cylindre de saphir monocristallin, ce procédé comprenant l'étape qui consiste, au moyen d'un outil de coupe, à effectuer dans une boule de monocristal de saphir que l'on a fait croître selon l'un des axes cristallographiques [A] ou [M] ou [C] un carottage selon une direction qui forme avec l'axe cristallographique de croissance de la boule de monocristal de saphir un angle dont la valeur est comprise entre 5 et 85°.

L'invention concerne également un germe de saphir monocristallin présentant une structure cristallographique rhomboédrique définissant trois axes cristallographiques [A], [C] et [M] mutuellement perpendiculaires et respectivement perpendiculaires aux plans cristallographiques A (11-20), C (0001) et M (10-10) de la structure rhomboédrique, ce germe de saphir monocristallin étant une plaque délimitée par deux faces planes qui s'étendent parallèlement et à distance l'une de l'autre, l'un des axes cristallographiques de la plaque de saphir monocristallin formant avec une normale aux faces planes de cette plaque de saphir monocristallin un angle dont la valeur est comprise entre 5 et 85°.

L'invention concerne également un germe de saphir monocristallin présentant une structure cristallographique rhomboédrique définissant trois axes cristallographiques [A], [C] et [M] mutuellement perpendiculaires et respectivement perpendiculaires aux plans cristallographiques A (11-20), C (0001) et M (10-10) de la structure rhomboédrique, ce germe de saphir monocristallin étant un barreau de saphir monocristallin dont l'un des axes cristallographiques forme avec une normale à une section droite de ce barreau de saphir monocristallin un angle dont la valeur est comprise entre 5 et 85°.

L'invention concerne également une ébauche de glace montre délimitée par deux faces qui s'étendent à distance l'une de l'autre et dont l'une au moins est plane, cette ébauche étant réalisée en saphir monocristallin présentant une structure cristallographique rhomboédrique définissant trois axes cristallographiques [A], [C] et [M] mutuellement perpendiculaires et respectivement perpendiculaires aux plans cristallographiques A (11-20), C (0001) et M (10-10) de la structure rhomboédrique, l'un des axes cristallographiques formant avec une normale à la face plane de l'ébauche un angle dont la valeur est comprise entre 5 et 85°, de sorte que l'axe cristallographique n'est pas compris dans la face plane de l'ébauche.

L'invention concerne enfin des composants d'habillage et fonctionnels pour l'horlogerie et fla bijouterie, notamment des ponts, des platines, des glaces, des boîtes et des cadrans de montre ou bien encore des maillons de bracelet, découpés dans un monocristal de saphir obtenu conformément au procédé de l'invention.

Grâce à ces caractéristiques, la présente invention procure un procédé qui permet de fabriquer des glaces de montres dans des conditions d'usinage facilitées. Plus précisément, les glaces de montres obtenues grâce au procédé selon l'invention sont découpées dans des monocristaux de saphir obtenus par croissance cristalline au contact d'un germe de saphir monocristallin du type d'une plaque ou d'un barreau qui est usiné de sorte que l'un des axes cristallographiques [A], [C] ou [M] de la plaque ou du barreau de saphir monocristallin forme avec la normale aux faces planes de la plaque, respectivement avec la normale à une section droite du barreau, un angle compris entre 5 et 85°. Les ébauches de glaces de montres qui sont découpées dans un monocristal de saphir obtenu par mise en œuvre du procédé selon l'invention ont un de leurs axes cristallographiques [A], [C] ou [M] décalé angulairement par rapport à une normale à leur surface de la même valeur que la désorientation de l'un des axes cristallographiques [A], [C] ou [M] du germe de saphir à partir duquel le monocristal de saphir dans lequel ces ébauches sont découpées est obtenu. Par conséquent, le décalage angulaire de l'axe cristallographique [A], [C] ou [M] par rapport à la normale aux faces planes de la plaque ou de la section droite du barreau de saphir monocristallin qui sert de germe pour la croissance cristalline du monocristal de saphir a pour conséquence que l'axe cristallographique [C] n'est généralement pas compris dans le plan des ébauches des glaces de montres, de sorte que la plus grande fragilité à l'usinage que l'on rencontre habituellement aux endroits où cet axe cristallographique [C] coupe les bords des ébauches des glaces de montres est généralement évitée. Les ébauches de glaces de montres sont donc moins dures et par conséquent plus faciles à usiner. En particulier, étant donné que ces ébauches de glaces de montres sont moins fragiles, les risques que les bords de ces ébauches s'ébrèchent en cours d'usinage sont considérablement réduits. En outre, les glaces de montres obtenues grâce au procédé de l'invention présentent peu, voire pas de dislocations et de changements locaux et incontrôlés d'orientation du monocristal de saphir.

### Brève description des figures

D'autres caractéristiques et avantages de la présente invention ressortiront plus clairement de la description détaillée qui suit d'un exemple de mise en œuvre du procédé selon l'invention, cet exemple étant donné à titre purement illustratif et non limitatif seulement en liaison avec le dessin annexé sur lequel :
- la figure 1 illustre un procédé de croissance cristalline de type EFG permettant l'obtention de plusieurs monocristaux de saphir à partir d'un germe de saphir monocristallin du type d'une plaque préparé conformément à l'invention ;
- la figure 2 illustre une ébauche de glace de montre découpée dans un monocristal de saphir obtenu par croissance cristalline au contact d'un germe de saphir monocristallin du type d'une plaque préparé conformément à l'invention ;
- la figure 3 illustre un germe de saphir monocristallin du type d'un barreau préparé conformément à l'invention ;
- la figure 4A illustre une boule dite de Kyropoulos que l'on a fait croître selon l'axe cristallographique [A] et dans laquelle est prélevé un barreau qui servira de germe pour la croissance d'un monocristal de saphir conformément à l'invention ;
- la figure 4B illustre un monocristal de saphir du type d'une boule de Kyropoulos obtenu au moyen du germe de la figure 4A et dans lequel est prélevé au moyen d'un outil diamanté et selon la direction de croissance de ce monocristal de saphir un cylindre permettant d'obtenir des ébauches de glaces de montre conformes à l'invention ;
- la figure 4C illustre une boule dite de Kyropoulos dans laquelle est directement prélevé au moyen d'un outil diamanté un cylindre permettant d'obtenir des ébauches de glaces de montre conformes à l'invention ;
- la figure 5 est une vue de dessus d'une filière pour la croissance de monocristaux de saphir conformément à un autre mode d'exécution du procédé selon l'invention ;
- la figure 6 est une vue de côté en coupe de la filière de la figure 5 ;
- la figure 7 est une vue de dessus d'une glace de montre obtenue grâce au procédé selon l'invention et placée entre deux polariseurs croisés ;
- la figure 8 illustre schématiquement la découpe d'ébauches de glaces de montre dans un monocristal de saphir de type EFG ;
- la figure 9 illustre schématiquement la découpe d'ébauches de glaces de montre dans un cylindre de saphir monocristallin.

### Description détaillée de l'invention

La présente invention procède de l'idée générale inventive qui consiste à produire notamment des glaces de montres à partir d'une ébauche découpée dans un monocristal de saphir obtenu par croissance cristalline à l'état fondu dans un creuset au contact d'un germe de saphir monocristallin du type d'une plaque ou d'un barreau. L'originalité de l'invention réside notamment dans le fait que le germe de saphir monocristallin qui est utilisé pour faire croître le monocristal de saphir dans lequel sont découpées les ébauches de glaces est lui-même découpé dans un monocristal de saphir de façon que l'axe cristallographique [C] qui est perpendiculaire au plan cristallographique (0001) de la maille élémentaire du monocristal de saphir dans lequel sont découpées ces ébauches de glaces ne soit pas contenu dans le plan de ces dernières. Plus précisément, le premier monocristal de saphir est découpé de façon à ce que l'on obtienne un germe de saphir monocristallin du type d'une plaque à faces planes dans lequel l'un des axes cristallographiques [A], [C] ou [M] forme avec une normale aux faces planes de la plaque, respectivement avec une section droite du barreau, un angle dont la valeur est comprise entre 5 et 85°. Par suite, la désorientation des axes cristallographiques [A], [C] ou [M] dans le germe de saphir monocristallin se retrouve dans le monocristal de saphir que l'on fait croître au contact de ce germe de saphir monocristallin, puis dans les ébauches de glaces de montres qui sont découpées dans ce monocristal de saphir. Finalement, l'axe cristallographique [C] ne se trouve pas dans le plan des ébauches de glaces et ne coupe donc pas les bords de ces ébauches. La plus grande fragilité à l'usinage que l'on constate habituellement lorsque l'axe cristallographique [C] coupe les bords des ébauches des glaces de montres est ainsi évitée. Les ébauches de glaces de montres sont ainsi moins fragiles et par conséquent plus faciles à usiner. En particulier, les risques d'ébréchures sont considérablement réduits.

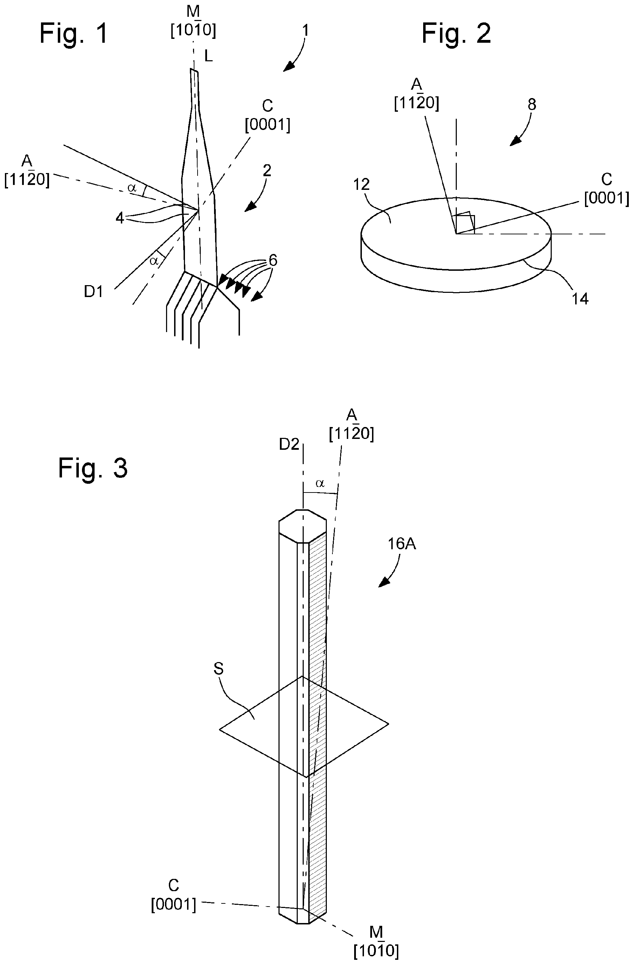

La figure 1 montre schématiquement un procédé de type EFG pour la fabrication d'un monocristal de saphir au moyen d'un germe de saphir monocristallin obtenu conformément à l'invention. Désigné par la référence numérique 1, le germe de saphir monocristallin est du type d'une plaque 2 délimitée par deux faces planes 4 qui s'étendent parallèlement et à distance l'une de l'autre. Ce germe de saphir monocristallin 1 présente une structure cristallographique rhomboédrique définissant trois axes cristallographiques [A], [C] et [M] mutuellement perpendiculaires et respectivement perpendiculaires aux plans cristallographiques A (11-20), C (0001) et M (10-10) de la maille élémentaire du saphir.

Selon l'invention, le germe de saphir monocristallin 1 est découpé dans un premier monocristal de saphir de sorte que par exemple l'axe cristallographique [C] de la plaque 2 résultante soit tourné autour de l'axe cristallographique [M] pour former avec une normale D1 aux faces planes 4 de cette plaque 2 un angle α dont la valeur est comprise entre 5 et 85°, par exemple 10°. Les axes cristallographiques [A], [C] et [M] étant mutuellement perpendiculaires, l'axe cristallographique [A] est également décalé du même angle α par rapport aux faces planes 4 de la plaque 2, tandis que l'axe cristallographique [M] tourne de 10° autour de lui-même et ne bouge donc pas.

On notera que les techniques pour découper un germe de saphir monocristallin dans un monocristal de saphir selon une direction privilégiée sont connues de l'homme du métier du domaine de la croissance de monocristaux de saphir et ne seront donc pas détaillées ici.

Comme il ressort de la figure 1, le germe de saphir monocristallin 1 est tiré selon l'axe cristallographique [M] qui définit la direction de croissance L de monocristaux de saphir 6. Chaque monocristal de saphir 6 est obtenu en amenant de l'alumine et/ou du saphir en fusion au contact du germe de saphir monocristallin 1 à l'un des sommets d'une filière, puis en tirant progressivement ce germe de saphir monocristallin 1 selon la direction de croissance L pour l'éloigner petit-à-petit de l'alumine et/ou du saphir en fusion et permettre la croissance progressive du monocristal de saphir 6.

Conformément à l'invention, le germe de saphir monocristallin 1 est utilisé pour faire croître les monocristaux de saphir 6 dans lesquels vont être découpées les ébauches 8 de glaces de montres 10. Ces ébauches 8 de glaces de montres 10 sont délimitées par deux faces qui s'étendent à distance l'une de l'autre et dont l'une au moins 12 est plane. Le germe de saphir monocristallin 1 est du type d'une plaque 2 elle-même découpée dans un monocristal de saphir initial de sorte que, par exemple, son axe cristallographique [C] soit tourné autour de l'axe cristallographique [M] pour former avec une normale D1 aux faces planes 4 de la plaque 2 un angle α dont la valeur est comprise entre 5 et 85°, par exemple 10°. Par la suite, la désorientation des axes cristallographiques [A] et [C] dans le germe de saphir monocristallin 1 se retrouve dans les monocristaux de saphir 6 que l'on fait croître au contact de ce germe de saphir monocristallin 1, puis dans les ébauches 8 de glaces de montres 10 qui sont découpées dans ces monocristaux de saphir 6.

Finalement, comme visible sur la figure 2, en raison de la désorientation des axes cristallographiques [A] et [C], l'axe cristallographique [C] ne se trouve pas compris dans la face plane 12 des ébauches 8 des glaces de montres 10 et ne coupe donc pas les bords 14 de ces ébauches 8. La plus grande fragilité à l'usinage que l'on constate habituellement aux endroits où cet axe cristallographique [C] coupe les bords 14 des ébauches 8 des glaces de montres 10 est ainsi évitée. Les ébauches 8 des glaces de montres 10 sont ainsi moins fragiles et par conséquent plus faciles à usiner. En particulier, les risques d'ébréchures sont considérablement réduits et les pertes sont plus faibles.

La figure 3 montre schématiquement un barreau de saphir monocristallin 16A utilisé dans un procédé de croissance cristalline par exemple de type Kyropoulos. Ce barreau de saphir monocristallin 16A présente une structure cristallographique rhomboédrique définissant trois axes cristallographiques [A], [C] et [M] mutuellement perpendiculaires et respectivement perpendiculaires aux plans cristallographiques A (11-20), C (0001) et M (10-10) de la maille élémentaire du saphir.

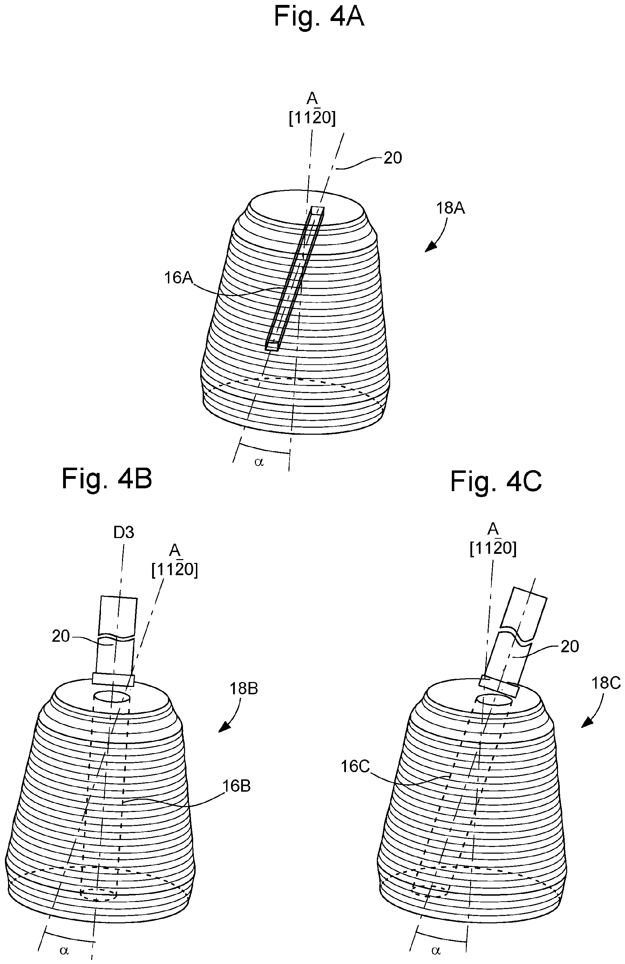

Selon l'invention et comme illustré à la figure 4A, le barreau de saphir monocristallin 16A est découpé dans une boule de monocristal de saphir 18A préalablement obtenue, de sorte que par exemple l'axe cristallographique [A] du barreau de saphir monocristallin 16A résultant soit tourné autour de l'axe cristallographique [M] pour former avec une normale D2 à une section droite S de ce barreau de saphir monocristallin 16A un angle α dont la valeur est comprise entre 5 et 85°, par exemple 10°. Les axes cristallographiques [A], [C] et [M] étant mutuellement perpendiculaires, l'axe cristallographique [C] est également décalé du même angle α par rapport à la section droite S du barreau de saphir monocristallin 16A, tandis que l'axe cristallographique [M] tourne autour de lui-même et ne bouge donc pas. Par la suite (voir figure 4B), la désorientation des axes cristallographiques [A] et [C] dans le barreau de saphir monocristallin 16A se retrouve dans la boule de monocristal de saphir 18B que l'on fait croître en mettant de l'alumine et/ou du saphir en fusion au contact de ce barreau de saphir monocristallin 16A. Par la suite, on peut, au moyen d'un outil de coupe 20 diamanté, découper un cylindre de saphir monocristallin 16B dans la boule de monocristal de saphir 18B selon la direction de croissance D3 de cette dernière depuis le barreau de saphir monocristallin 16A. Des ébauches 8 de glaces de montre 10 conformes à l'invention peuvent ensuite être à leur tour découpées dans ce cylindre de saphir monocristallin 16B.

On voit à la figure 4C une boule de monocristal de saphir 18C par exemple de type Kyropoulos dans laquelle on effectue un carottage au moyen de l'outil de coupe 20 selon une direction qui forme avec l'axe cristallographique [A] de croissance de cette boule de monocristal de saphir 18C un angle α dont la valeur est comprise entre 5 et 85°, par exemple 10°. Par ce moyen, des cylindres de saphir monocristallin 16C permettant la découpe d'ébauches 8 de glaces de montre 10 répondant à l'invention peuvent également être obtenus.

On notera que les techniques pour découper selon une direction privilégiée un germe de saphir monocristallin dans une boule de monocristal de saphir préalablement obtenue, par exemple de type Kyropoulos, que ce germe soit du type d'une plaque 2 à faces planes 4 ou du type d'un barreau 16A sont connues de l'homme du métier du domaine de la croissance de monocristaux de saphir et ne seront donc pas détaillées ici.

Finalement, en raison de la désorientation de l'axe cristallographique [A] par rapport à la normale à une section droite S du barreau de saphir monocristallin 16A, l'axe cristallographique [C] ne se trouve généralement pas dans la face plane 12 des ébauches 8 des glaces de montres 10 et donc ne coupent généralement pas les bords 14 de ces ébauches 8. La plus grande fragilité que l'on constate habituellement aux endroits où cet axe cristallographique [C] coupe les bords 14 des ébauches 8 des glaces de montres 10 est ainsi évitée. Les ébauches 8 des glaces de montres 10 sont ainsi moins fragiles et par conséquent plus faciles à usiner. En particulier, les risques d'ébréchures sont considérablement réduits et les pertes sont plus faibles.

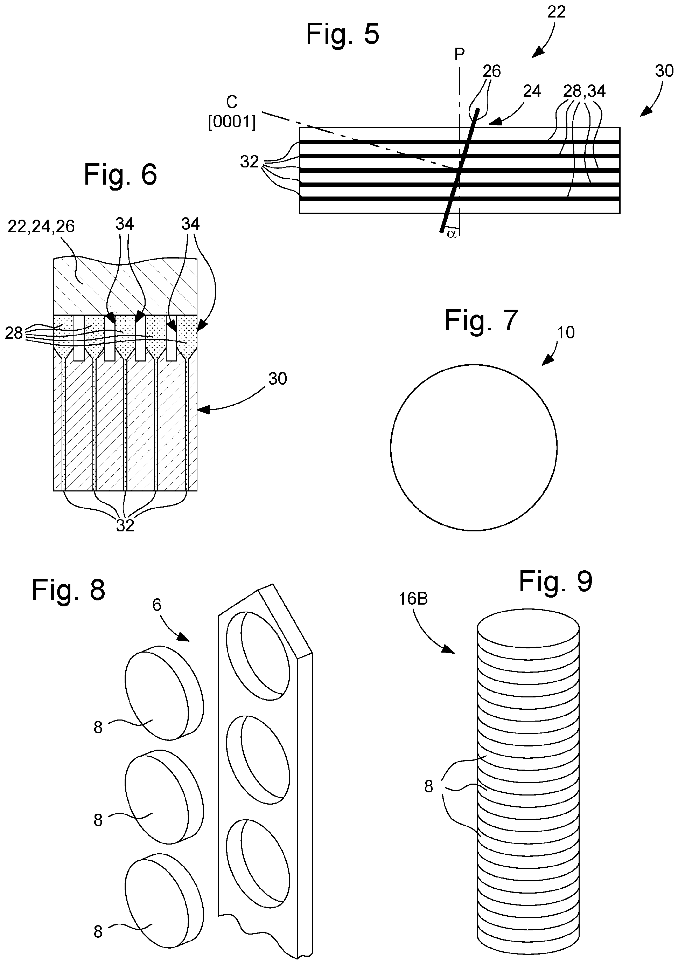

Il va de soi que la présente invention n'est pas limitée aux modes de mise en œuvre qui viennent d'être décrits et que diverses modifications et variantes simples peuvent être envisagées sans sortir du cadre de l'invention tel que défini par les revendications annexées. En particulier, plutôt que de préparer un germe de saphir monocristallin du type d'une plaque dont un axe cristallographique forme un angle non nul par rapport à la normale aux faces planes qui délimitent cette plaque comme expliqué ci-dessus, il est également envisageable, comme illustré aux figures 5 et 6, d'utiliser un germe de saphir monocristallin 22 du type d'une première plaque 24 dont par exemple l'axe cristallographique [C] est classiquement perpendiculaire aux faces planes 26 qui délimitent cette première plaque 24. Selon une forme spéciale d'exécution de l'invention, un tel germe de saphir monocristallin 22 est utilisé pour faire croître des monocristaux de saphir 28 aux sommets d'une filière 30 qui se compose d'une pluralité de canaux 32 qui s'étendent parallèlement et à distance les uns des autres et à l'intérieur desquels remonte de l'alumine et/ou du saphir en fusion. Cette alumine et/ou ce saphir en fusion viennent ensuite au contact du germe de saphir monocristallin 22 et commence à cristalliser pour former les monocristaux de saphir 28 sous forme de secondes plaques. Ces secondes plaques de saphir monocristallin sont délimitées chacune par deux faces planes 34 qui s'étendent parallèlement et à distance l'une de l'autre. Dans ce cas, en inclinant le germe de saphir monocristallin 22 d'un angle α dont la valeur est comprise entre 5 et 85°, par exemple 10°, par rapport à une perpendiculaire P au plan dans lequel s'étendent les canaux 32 de la filière 30, les secondes plaques de saphir monocristallin qui résultent de la croissance cristalline présentent la même désorientation de leur axe cristallographique [A] par rapport à la normale à leurs faces planes 34 que les plaques obtenues au moyen d'un germe de saphir monocristallin présentant une désorientation de ses axes cristallographiques comme décrit ci-dessus en liaison avec la figure 1.

La figure 7 est une vue de dessus d'une glace de montre 10 obtenue grâce au procédé de l'invention et placée entre deux polariseurs croisés. On voit sur cette figure 7 qu'aucun défaut tel que dislocations ou changement locaux incontrôlés d'orientation n'est visible dans la glace de montre 10. On aura également bien compris que, conformément au procédé de l'invention, on fait fusionner de l'alumine et/ou du saphir. Ces matériaux peuvent être purs ou dopés. Les matériaux de dopage sont préférentiellement mais non limitativement choisis dans le groupe formé par le titane, le fer, le chrome, le cobalt et le vanadium utilisés seuls ou en combinaison. Quant au saphir utilisé, il s'agit préférentiellement de rebuts tels que des cristaux de saphir de mauvaise qualité ou bien des chutes d'usinage ou des rebuts provenant des différentes étapes de fabrication des glaces de montre 10. La présente invention a été tout particulièrement décrite en liaison avec la fabrication de glaces de montre 10. Il va de soi que cet exemple est donné à titre purement illustratif et non limitatif seulement et que la présente invention s'applique plus généralement à la fabrication de composants d'habillage et fonctionnels notamment pour l'horlogerie et la bijouterie tels que des ponts, des platines, des boîtes et des cadrans de montre ou bien encore des maillons de bracelet.

Comme illustré à la figure 8, des ébauches 8 de glaces de montre 10 sont découpées dans un monocristal de saphir 6 de type EFG. Comme illustré à la figure 9, on comprendra que les ébauches 8 de glaces de montre 10 sont usinées dans un cylindre de saphir monocristallin 16B découpé dans la boule de monocristal de saphir 18B selon la direction de croissance D3 de cette dernière depuis le barreau de saphir monocristallin 16A. Autrement dit, les ébauches 8 de glaces de montre 10 sont découpées perpendiculairement à la direction de croissance D3 de la boule de monocristal de saphir 18B. Typiquement, l'épaisseur des ébauches 8 de glaces de montre 10 est comprise entre 1 à 2 mm et peut atteindre 10 mm. On notera enfin que, dans tout ce qui précède, le terme « barreau » s'applique à un germe, et le terme « cylindre » s'applique à un monocristal de saphir.

### Nomenclature

- 1.: Germe de saphir monocristallin
- 2.: Plaque
- 4.: Faces planes
- α: Angle
- D1: Normale
- L: Direction de croissance
- 6.: Monocristal de saphir
- 8.: Ebauches
- 10.: Glaces de montres
- 12.: Face plane
- 14.: Bords
- 16A.: Barreau de saphir monocristallin
- 16B.: Cylindre de saphir monocristallin
- 16C.: Cylindre de saphir monocristallin
- 18A.: Boule de monocristal de saphir
- 18B.: Boule de monocristal de saphir
- 18C.: Boule de monocristal de saphir
- D2: Normale
- S: Section droite
- D3: Direction de croissance
- 20.: Outil de coupe
- 22.: Germe de saphir monocristallin
- 24.: Première plaque
- 26.: Faces planes
- 28.: Monocristaux de saphir
- 30.: Filière
- 32.: Canaux
- 34.: Faces planes

## Revendications

1. Procédé de fabrication d'un germe de saphir monocristallin, ce germe de saphir monocristallin (1) présentant une structure cristallographique rhomboédrique définissant trois axes cristallographiques [A], [C] et [M] mutuellement perpendiculaires et respectivement perpendiculaires aux plans cristallographiques A (11-20), C (0001) et M (10-10), ce germe de saphir monocristallin (1) étant une plaque (2) délimitée par deux faces planes (4) qui s'étendent parallèlement et à distance l'une de l'autre, cette plaque (2) de saphir monocristallin étant obtenue à partir d'un monocristal de saphir initial que l'on découpe de sorte que l'un des axes cristallographiques [A], [C] ou [M] de la plaque (2) de saphir monocristallin forme avec une normale (D1) aux faces planes (4) de cette plaque de saphir monocristallin (2) un angle (a) dont la valeur est comprise entre 5 et 85°.

2. Procédé de fabrication d'un germe de saphir monocristallin, ce germe de saphir monocristallin présentant une structure cristallographique rhomboédrique définissant trois axes cristallographiques [A], [C] et [M] mutuellement perpendiculaires et respectivement perpendiculaires aux plans cristallographiques A (11-20), C (0001) et M (10-10) de la structure rhomboédrique, ce germe de saphir monocristallin étant un barreau de saphir monocristallin (16A) préalablement obtenu à partir d'un monocristal de saphir (18A) initial que l'on découpe de sorte que l'un des axes cristallographiques [A], [C] ou [M] du barreau de saphir monocristallin (16A) forme avec une normale (D2) à une section droite (S) de ce barreau de saphir monocristallin (16A) un angle (a) dont la valeur est comprise entre 5 et 85°.

3. Procédé de fabrication d'un monocristal de saphir (6 ; 18B), ce procédé comprenant l'étape qui consiste à faire fusionner de l'alumine et/ou du saphir dans un creuset, puis à amener l'alumine et/ou le saphir en fusion en contact avec un germe de saphir monocristallin obtenu par mise en œuvre du procédé selon l'une des revendications 1 et 2 afin de faire progressivement cristalliser l'alumine et/ou le saphir en fusion selon une direction de croissance pour former le monocristal de saphir (6).

4. Procédé de fabrication d'un cylindre de saphir monocristallin (16C), ce cylindre de saphir monocristallin (16C) présentant une structure cristallographique rhomboédrique définissant trois axes cristallographiques [A], [C] et [M] mutuellement perpendiculaires et respectivement perpendiculaires aux plans cristallographiques A (11-20), C (0001) et M (10-10) de la structure rhomboédrique, ce procédé comprenant l'étape qui consiste, au moyen d'un outil de coupe (20), à effectuer dans une boule de monocristal de saphir (18C) que l'on a fait croître selon l'un des axes cristallographiques [A] ou [M] ou [C] un carottage selon une direction qui forme avec l'axe cristallographique de croissance de la boule de monocristal de saphir (18C) un angle dont la valeur est comprise entre 5 et 85°.

5. Procédé de fabrication d'un monocristal de saphir (28) obtenu par cristallisation à l'état fondu à un sommet d'une filière, ce procédé comprenant l'étape qui consiste à faire fusionner de l'alumine et/ou du saphir dans un creuset, puis à amener au travers de canaux (32) de la filière (30) l'alumine et/ou le saphir en fusion en contact avec un germe de saphir monocristallin (22) préalablement obtenu afin de faire progressivement cristalliser l'alumine et/ou le saphir en fusion selon une direction de croissance pour former le monocristal de saphir (28), le germe de saphir monocristallin (22) présentant une structure cristallographique rhomboédrique définissant trois axes cristallographiques [A], [C] et [M] mutuellement perpendiculaires et respectivement perpendiculaires aux plans cristallographiques A (11-20), C (0001) et M (10-10) de la structure rhomboédrique, le germe de saphir monocristallin (22) étant une première plaque (24) délimitée par deux faces planes (26) qui s'étendent parallèlement et à distance l'une de l'autre, l'un des axes cristallographiques [A], [C] ou [M] étant perpendiculaire aux faces planes (26) de la première plaque (24) de saphir monocristallin, cette première plaque (24) de saphir monocristallin étant inclinée d'un angle (a) dont la valeur est comprise entre 5 et 85° par rapport à une perpendiculaire (P) au plan défini par les canaux (32) de la filière (30), le monocristal de saphir (28) résultant de la croissance cristalline étant une seconde plaque de saphir monocristallin délimitée par deux faces planes (34) qui s'étendent parallèlement et à distance l'une de l'autre, cette seconde plaque de saphir monocristallin présentant une désorientation de l'un de ses axes cristallographiques [A], [M] ou [C] par rapport à la normale à ses faces planes (34) qui correspond à l'inclinaison d'angle (a) de la première plaque (24) par rapport aux canaux (32) de la filière (30).

6. Procédé de fabrication selon la revendication 3, **caractérisé en ce que** l'axe cristallographique [A], [M] ou [C] forme avec la normale (D1) aux faces planes (4) de la plaque de saphir monocristallin (2) un angle dont la valeur est comprise entre 25 et 35°.

7. Procédé de fabrication selon la revendication 6, **caractérisé en ce que** l'axe cristallographique [A], [M] ou [C] forme avec la normale (D1) aux faces planes (4) de la plaque de saphir monocristallin (2) un angle dont la valeur est comprise entre 5 et 15°.

8. Procédé de fabrication selon la revendication 3, **caractérisé en ce que** l'axe cristallographique [A], [M] ou [C] forme avec la normale (D2) à la section droite (S) du barreau de saphir monocristallin (16A) un angle dont la valeur est comprise entre 25 et 35°.

9. Procédé de fabrication selon la revendication 8, **caractérisé en ce que** l'axe cristallographique [A], [M] ou [C] forme avec la normale (D2) à la section droite (S) du barreau de saphir monocristallin (16A) un angle dont la valeur est comprise entre 5 et 15°.

10. Procédé de fabrication selon l'une des revendications 3 à 9, **caractérisé en ce que** le procédé de fabrication du monocristal de saphir est choisi parmi les procédés EFG, HEM, Kyropoulos, Czochralski, Bridgman Vertical, Bridgman Horizontal et Micro Pulling Down.

11. Procédé de fabrication selon l'une des revendications 3 à 10, **caractérisé en ce que** l'alumine et/ou le saphir que l'on fait fusionner sont purs ou dopés.

12. Procédé de fabrication selon la revendication 11, **caractérisé en ce que** l'on utilise des rebuts de saphir.

13. Procédé de fabrication selon l'une des revendications 3 à 12, **caractérisé en ce que**, une fois le monocristal de saphir obtenu, on découpe des composants d'habillage ou fonctionnels pour l'horlogerie et la bijouterie dans ce monocristal de saphir.

14. Procédé de fabrication selon la revendication 13, **caractérisé en ce que** les composants d'habillage ou fonctionnels sont des ponts, des platines, des boîtes et des cadrans de montre ou bien des maillons de bracelet.

15. Germe de saphir monocristallin (1) présentant une structure cristallographique rhomboédrique définissant trois axes cristallographiques [A], [C] et [M] mutuellement perpendiculaires et respectivement perpendiculaires aux plans cristallographiques A (11-20), C (0001) et M (10-10) de la structure rhomboédrique, ce germe de saphir monocristallin (1) étant une plaque (2) délimitée par deux faces planes (4) qui s'étendent parallèlement et à distance l'une de l'autre, l'un des axes cristallographiques [A], [C] ou [M] de la plaque de saphir monocristallin (2) formant avec une normale (D1) aux faces planes (4) de cette plaque de saphir monocristallin (2) un angle (a) dont la valeur est comprise entre 5 et 85°.

16. Germe de saphir monocristallin présentant une structure cristallographique rhomboédrique définissant trois axes cristallographiques [A], [C] et [M] mutuellement perpendiculaires et respectivement perpendiculaires aux plans cristallographiques A (11-20), C (0001) et M (10-10) de la structure rhomboédrique, ce germe de saphir monocristallin étant un barreau de saphir monocristallin (16A) dont l'un des axes cristallographiques [A], [C] ou [M] forme avec une normale (D2) à une section droite (S) de ce barreau de saphir monocristallin (16A) un angle (a) dont la valeur est comprise entre 5 et 85°.

17. Ebauche (8) de glace de montre (10) délimitée par deux faces qui s'étendent à distance l'une de l'autre et dont l'une au moins (12) est plane, cette ébauche (8) étant réalisée en saphir monocristallin présentant une structure cristallographique rhomboédrique définissant trois axes cristallographiques [A], [C] et [M] mutuellement perpendiculaires et respectivement perpendiculaires aux plans cristallographiques A (11-20), C (0001) et M (10-10) de la structure rhomboédrique, l'un des axes cristallographiques [A], [C] ou [M] formant avec une normale à la face plane de l'ébauche un angle dont la valeur est comprise entre 5 et 85°, de sorte que l'axe cristallographique [C] n'est pas compris dans la face plane (12) de l'ébauche (8) de glace de montre (10).

18. Composants d'habillage et fonctionnels pour l'horlogerie et la bijouterie découpés dans un monocristal de saphir obtenu par mise en œuvre du procédé de fabrication selon l'une des revendications 3 à 13.

19. Composants d'habillage et fonctionnels selon la revendication 18, **caractérisé en ce qu'**il s'agit de ponts, de platines, de glaces, de boîtes et de cadrans de montre ou bien encore de maillons de bracelet.
